(19) Europäisches Patentamt
European Patent Office
Office européen des brevets

(11) EP 2 808 900 A2

(12) EUROPEAN PATENT APPLICATION

(43) Date of publication:
03.12.2014 Bulletin 2014/49

(51) Int Cl.:
H01L 31/032 (2006.01)       H01L 31/0392 (2006.01)

(21) Application number: 14161277.0

(22) Date of filing: 24.03.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 30.05.2013 KR 20130062106

(71) Applicant: Samsung SDI Co., Ltd.
Yongin-si, Gyeonggi-do (KR)

(72) Inventor: Kim, Dong-Jin
Gyeonggi-do (KR)

(74) Representative: Walaski, Jan Filip et al
Venner Shipley LLP
200 Aldersgate
London
EC1A 4HD (GB)

(54) **Solar cell and method of manufacturing the same**

(57) A solar cell includes a substrate, a barrier layer on the substrate, a back electrode layer on the barrier layer, a light absorption layer on the back electrode layer, a buffer layer on the light absorption layer, and a transparent electrode layer on the buffer layer. The barrier layer is selectively formed on the substrate. The substrate may include alkali elements. Accordingly, since alkali elements may be uniformly distributed in the light absorption layer, the efficiency of the solar cell may be improved.

FIG. 1

100
160
150
140
130
120
110

EP 2 808 900 A2

**Description**

The present invention is directed to a solar cell and methods of manufacturing the same.

As conventional energy resources, such as oil and coal, are expected to be depleted, interest in various alternative energy resources replacing the conventional energy resources is increasing. Among the alternative energy resources, solar cells that convert solar energy directly into electrical energy using a p-n junction of semiconductor elements have attracted attention.

Solar cells may be classified into crystalline silicon solar cells, amorphous silicon solar cells, compound solar cells and dye-sensitized solar cells according to their materials. At present, the crystalline silicon solar cells are most widely used. However, the crystalline silicon solar cells have a high unit production cost for electricity generation efficiency.

Embodiments are directed to a solar cell that includes a substrate, a barrier layer on the substrate, a back electrode layer on the barrier layer, a light absorption layer on the back electrode layer, a buffer layer on the light absorption layer, and a transparent electrode layer on the buffer layer. The barrier layer may be selectively formed on the substrate.

A thickness of the barrier layer at a first point on the substrate may be different from a thickness of the barrier layer at a second point on the substrate.

The first point may be closer to an edge of the substrate than the second point. The thickness of the barrier layer at the first point may be greater than the thickness of the barrier layer at the second point.

The thickness of the barrier layer may increase discontinuously.

The thickness of the barrier layer may increase discontinuously in a stepped manner.

The thickness of the barrier layer may change continuously.

The substrate may be formed of a material including alkali elements.

The light absorption layer may be formed of a Group I-III-VI compound. The light absorption layer may include alkali elements diffused therein.

The barrier layer may control a diffusion of the alkali elements from the substrate into the light absorption layer.

The barrier layer may be formed of at least one of silicon oxide, silicon nitride, and silicon oxynitride.

Embodiments are also directed to a method of manufacturing a solar cell that includes selectively forming a barrier layer on a substrate, forming a back electrode layer on the barrier layer, forming a light absorption layer on the back electrode layer, forming a buffer layer on the light absorption layer, and forming a transparent electrode layer on the buffer layer. Forming the light absorption layer on the back electrode layer may include a heat treatment. During the heat treatment, the substrate may have a non-uniform temperature distribution in which a temperature of a first point is different from a temperature of a second point. The barrier layer may have a first thickness corresponding to the first point and a second thickness corresponding to the second point, the first thickness and the second thickness being different.

During the heat treatment, a temperature of the first point may be higher than a temperature of the second point. The first thickness of the barrier layer may be greater than the second thickness of the barrier layer.

The first point may be closer to an edge of the substrate than the second point.

The thickness of the barrier layer may increase toward the edge of the substrate.

The thickness of the barrier layer may increase discontinuously.

The thickness of the barrier layer may increase discontinuously in a stepped manner.

The thickness of the barrier layer may change continuously.

The light absorption layer may be formed by forming a copper-indium-gallium metal precursor film on the back electrode layer and then performing the heat treatment in a hydrogen selenide gas atmosphere.

The substrate may include alkali elements. The barrier layer may cause the alkali elements to be uniformly diffused from the substrate into the light absorption layer in the heat treatment.

According to an aspect of the present invention, there is provided a method of doping a light absorption layer of a solar cell, so that the layer is substantially uniformly doped. The method comprises forming a barrier layer to be thicker in regions where the temperature of the substrate is higher during heat treatment, to decrease the amount of doping agent that is diffused into the light absorption layer in those regions. The thickness profile of the barrier layer need not exactly correspond to the temperature profile of the substrate. For example, placing a uniformly thick barrier layer around the outside of the substrate and leaving a central portion without a barrier layer, will still improve the uniformity of the distribution.

Features will become apparent to those of skill in the art by describing in detail exemplary embodiments with reference to the attached drawings in which:

FIG. 1 is a schematic cross-sectional view of a solar cell according to an embodiment;
FIG. 2 is a diagram showing the relationship between the temperature of a substrate and the diffusion of alkali ions;
FIG. 3 is a diagram showing the relationship between the thickness of a barrier layer and the diffusion of alkali ions;

FIG. 4 is a diagram showing only a substrate and a barrier layer of the solar cell illustrated in FIG. 1; and

FIGS. 5 to 7 are diagrams of modifications of the substrate and barrier layer illustrated in FIG. 4.

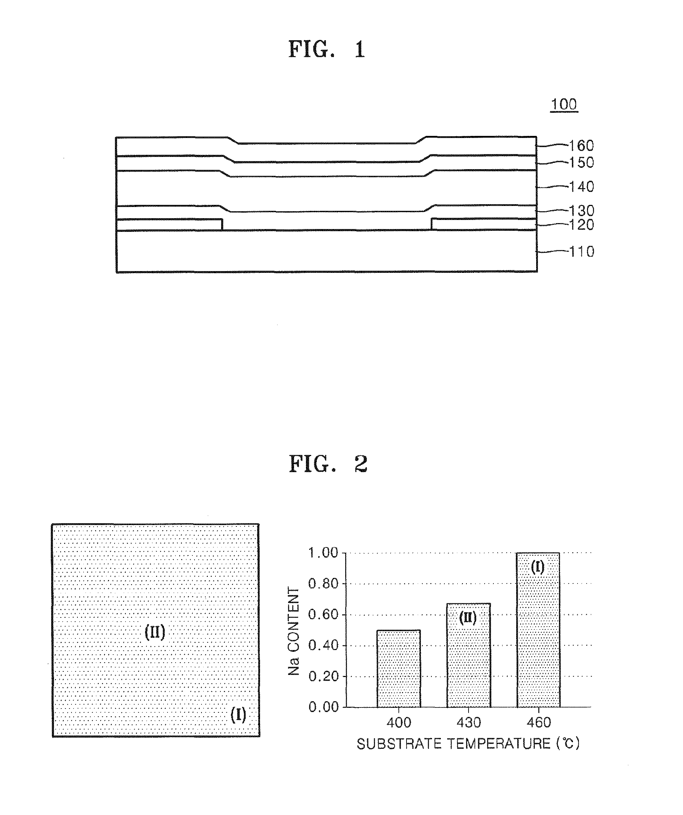

Referring to FIG. 1, the solar cell 100 may include a barrier layer 120, a back electrode layer 130, a light absorption layer 140, a buffer layer 150, and a transparent electrode layer 160 that are sequentially stacked on a substrate 110 in this order.

The substrate 110 may be formed of a glass material or a polymer material. A glass substrate may include soda-lime glass, and a polymer substrate may include polyimide, as examples.

The substrate 100 may be formed of a material including alkali elements, more generally referred to as a dopant, in order to thermally diffuse alkali elements into the light absorption layer 140 in a heat treatment for forming the light absorption layer 140, as described below. For example, in the heat treatment for forming the light absorption layer 140, sodium (Na) may be eluted from the soda-lime glass, and the Na may be diffused into the light absorption layer 140 formed of a Group I-III-VI compound, thereby further improving the efficiency of the light absorption layer 140. Herein, the term "alkali elements" may refer generally to alkali metal atoms, alkali metal ions, or alkali metal-containing compounds or salts.

In the heat treatment for forming the light absorption layer 140, the barrier layer 120 causes the alkali elements to be uniformly diffused from the substrate 110 into the light absorption layer 140. The barrier layer 120 may be selectively formed on the substrate 110. Herein, the term "selectively formed on the substrate 110" includes formed partially on the substrate 110 and formed completely on the substrate 110 to different thicknesses at different positions.

In an embodiment, the barrier layer 120 may be formed completely on the substrate 110 to a non-uniform thickness. For example, the thickness of the barrier layer 120 may be different between one point and another point on the substrate 110. For example, the thickness of the barrier layer may increase toward an edge of the substrate 110. The barrier layer 120 will be described below with reference to FIGS. 2 to 6.

The barrier layer 120 may be formed of at least one of a silicon oxide, a silicon nitride, and a silicon oxynitride, as examples.

An alkali-containing layer (not illustrated) may be alternatively or additionally formed between the substrate 110 and the barrier layer 120 to diffuse the alkali elements into the light absorption layer 140. For example, the alkali-containing layer (not illustrated) may include Na, and may be formed on the substrate 110 by coating or the like.

The back electrode layer 130 may collect electric charges formed by a photoelectric effect, and may reflect light that has penetrated the light absorption layer 140, such that the light may be re-absorbed by the light absorption layer 140. The back electrode layer 130 may be formed of a high-conductance and high-optical reflectance metal material, such as molybdenum (Mo), aluminum (Al), or copper (Cu), as examples.

For example, the back electrode layer 130 may be formed of Mo in consideration of high conductivity, ohmic contact with the light absorption layer 140, and high-temperature stability under a selenium (Se) atmosphere.

When the back electrode layer 130 includes Mo, a $MoSe_2$ layer (not illustrated) may be formed between the back electrode layer 130 and the light absorption layer 140 by the Na eluted from the substrate 110 in the heat treatment for forming the light absorption layer 140. The $MoSe_2$ layer (not illustrated) may increase the junction force between the back electrode layer 130 and the light absorption layer 140, and may act as an energy barrier that prevents electrons formed by a photoelectric effect from being discharged through the back electrode layer 130.

Also, the back electrode layer 130 may be formed as a multiple layer film in order to secure contact with the substrate 110 and provide the resistance characteristics of the back electrode layer 130.

The light absorption layer 140 may be formed of a Group I-III-VI compound. For example, the light absorption layer 140 is formed of a copper-indium-selenide (CIS) compound including copper (Cu), indium (In), and Se, to form a p-type semiconductor layer and absorb incident solar light. In other implementations, the light absorption layer 140 may be formed of a copper-indium-gallium-selenide ($Cu(In, Ga)Se_2$ or CIGS) compound including copper (Cu), indium (In), gallium (Ga), and Se. The light absorption layer 140 may be formed to a thickness of about 0.7 $\mu m$ to about 2 $\mu m$.

The buffer layer 150 reduces the bandgap difference between the light absorption layer 140 and the transparent electrode layer 160, and reduces an electron-hole recombination that may occur at the interface between the light absorption layer 140 and the transparent electrode layer 160. The buffer layer 150 may be formed of CdS, ZnS, $In_2S_3$, or $Zn_xMg_{(1-x)}O$, as examples.

The transparent electrode layer 160 may form a p-n junction with the light absorption layer 140. The transparent electrode layer 160 may be formed of a transparent conductive material such as ZnO:B, ZnO:Al, ZnO:Ga, indium tin oxide (ITO), or indium zinc oxide (IZO) to capture electric charges formed by a photoelectric effect.

Also, although not illustrated in the drawings, a top surface of the transparent electrode layer 160 may be textured in order to reduce the reflection of incident solar light and increase the light absorption into the light absorption layer 140.

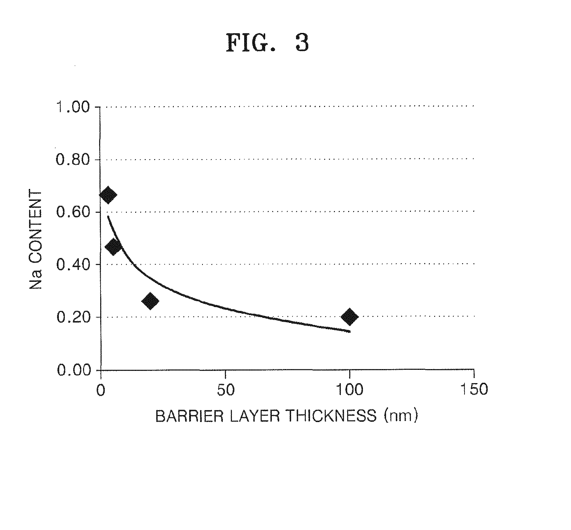

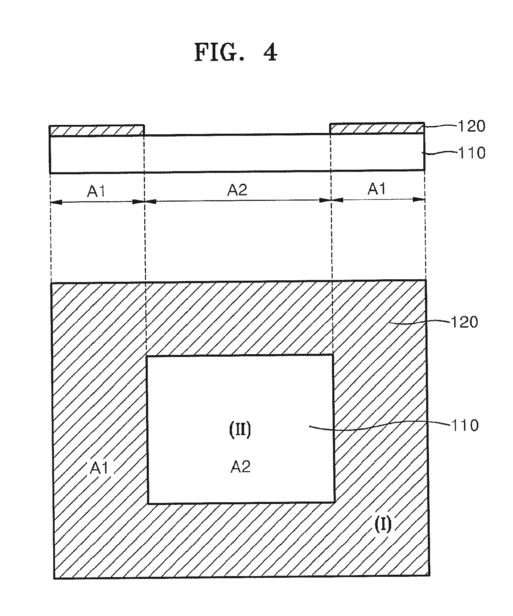

FIG. 2 illustrates a diagram showing the relationship between the temperature of the substrate 110 and the diffusion of alkali ions. FIG. 3 illustrates a diagram showing the relationship between the thickness of the barrier layer 120 and the diffusion of alkali ions. FIG. 4 illustrates a diagram showing only the substrate 110 and the barrier layer 120 of FIG. 1. Hereinafter, FIGS. 3 and 4 will be described in association with FIG. 1.

First, FIG. 2 illustrates the relation between the temperature of a substrate 110 formed of soda-lime glass and the diffusion of Na when the heat treatment for forming the light absorption layer 140 is performed at a temperature of about 460°C.

Specifically, FIG. 2 illustrates the temperatures of the substrate 110 that are measured at a first point I and a second point II of the substrate 110, and the relative content of alkali elements in the light absorption layer 140 measured at the same point, when the light absorption layer 140 is formed without the barrier layer 120 being formed on the substrate 110. The light absorption layer 140 is formed by sputtering/selenization.

It may be seen from FIG. 2 that the substrate 110 has a non-uniform temperature distribution in which the temperature of the first point I is different from the temperature of the second point II in the heat treatment for forming the light absorption layer 140, and the Na content in the light absorption layer 140 changes according to the temperatures of the respective first and second points I and II.

The first point I is closer to the edge of the substrate 110 than the second point II, and the measured temperature (460°C) of the first point I is higher than the measured temperature (430°C) of the second point II. Generally, in the heat treatment for forming the light absorption layer 140, the temperature of the substrate 110 decreases toward a center of the substrate 110. Accordingly, it may be seen that the Na content in the light absorption layer 140 formed at the second point II decreases to 0.62 when the Na content in the light absorption layer 140 formed at the first point I is set to 1.00.

Also, it may be seen that the Na content in the light absorption layer 140 further decreases when the temperature decreases to 400°C. This is because the thermal diffusion of the Na included in the substrate 110 may occur more actively as the temperature of the substrate 110 increases.

FIG. 3 illustrates the results of measurement of the Na content in the light absorption layer 140 as the thickness of the barrier layer 120 changes. The substrate 100 and the light absorption layer 140 used are the same as those of FIG. 2, and the barrier layer 120 is formed of $SiO_2$. Also, the heat treatment temperature for forming the light absorption layer 140 is about 460°C, and the Na content is measured at the second point II of FIG. 2.

It may be seen from FIG. 3 that the Na content in the light absorption layer 140 decreases as the thickness of the barrier layer 120 increases. Without being bound to any theory, it is believed that the barrier layer 120 restricts the thermal diffusion of the Na.

In the heat treatment for forming the light absorption layer 140, the substrate 110 may have a non-uniform temperature distribution, and the barrier layer 120 may restrict the thermal diffusion of the Na. Therefore, when the barrier layer 120 is formed only at a higher-temperature region of the substrate 110, the Na may be more uniformly diffused throughout the light absorption layer 140, so that the efficiency of the solar cell 100 may be improved.

The results of FIG. 3 may be expressed as Equation 1 below.

[Equation 1]

$$Y=-0.124Ln(X) + 0.72$$

In Equation 1, Y is the Na content and X is the thickness of the barrier layer 120.

Therefore, when the temperature distribution of the substrate 110 in the heat treatment for forming the light absorption layer 140 and the corresponding Na content in the light absorption layer 140 are known, Equation 1 may be used to set a thickness of the barrier layer 120 that may cause the Na to be uniformly diffused throughout the light absorption layer 140 in the heat treatment for forming the light absorption layer 140.

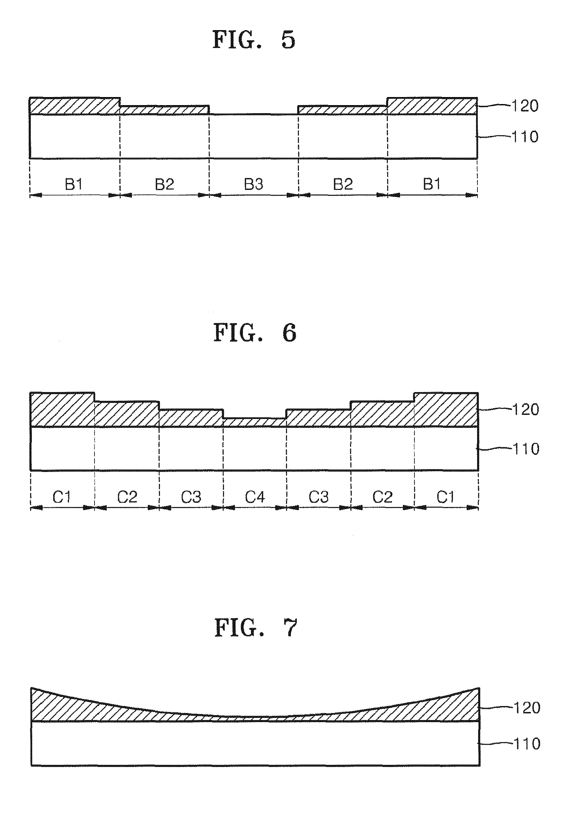

Also, a region in which the barrier layer 120 is formed may be selected by setting a predetermined range according to the temperature gradient of the substrate 110. FIG. 4 illustrates an example in which the substrate 110 is segmented into a center portion A2 and an edge portion A1, and the barrier layer 120 is formed only on the edge portion A1. This segmentation may be selected suitably according to the temperature variation of the substrate 110. In other implementations, the substrate 110 may be segmented into various regions, as illustrated in FIGS. 5 and 6.

Table 1 below shows the temperatures of the substrate 110 and the Na contents in the light absorption layer 140 in a case where the barrier layer 120 is formed as illustrated in FIG. 4 and in a case where the barrier layer 120 is not formed. Herein, the case where the barrier layer 120 is formed is identical to the case illustrated in FIG. 2, and the measurement positions are also the first point I and the second point II of FIG. 2. Also, the substrate 110 is formed of soda-lime glass, the heat treatment for forming the light absorption layer 140 is performed at about 460°C, and the barrier layer 120 is formed of $SiO_2$.

[Table 1]

| CASE | Measurement Position | Temperature (°C) | Barrier Layer Thickness (nm) | Relative Na Content |
|---|---|---|---|---|
| 1 | I | 460 | 0 | 1.598 |
| 2 | I | 460 | 30 | 1.065 |
| 3 | II | 430 | 0 | 1.000 |

In Table 1, CASE 3 corresponds to the result of measurement at the second point II of the substrate 110, and is used as a relative reference value (of 1.000) in Table 1, indicating that it has the same result in FIGS. 2 and 4.

CASE 1 corresponds to the result of measurement at the first point I illustrated in FIG. 2, and represents the temperature of the substrate 110 and the relative Na content in the light absorption layer 140 (relative to that in CASE 3), when the barrier layer 120 is not formed on the substrate 110. Thus, it may be seen that the Na content increases as compared to that in CASE 3. This is believed to be because the thermal diffusion of the Na at the first point I occurs more actively since the temperature of the substrate 110 is higher at the first point I than at the second point II as described above.

CASE 2 represents the temperatures of the substrate 110 that are measured at the first point I, and the relative Na content in the light absorption layer 140, in a case where the barrier layer 120 is formed to a thickness of about 30 nm on the first region A1 of the substrate 110. It may be seen that the temperature of the substrate 110 is equal to that in CASE 1, but the relative Na content is reduced to 1.065, which is substantially equal to that in CASE 3.

Therefore, according to the embodiment, the barrier layer 120 may be formed only at the higher-temperature region of the substrate 110. Accordingly, alkali ions, such as Na, may be uniformly diffused throughout the light absorption layer 140 even when the substrate 110 has a non-uniform temperature distribution in the heat treatment for forming the light absorption layer 140.

An alkali-containing layer (not illustrated) may be additionally formed between the substrate 110 and the barrier layer 120 to diffuse the alkali elements into the light absorption layer 140. Since the alkali-containing layer (not illustrated) has substantially the same temperature distribution as the substrate 110, the alkali elements may be uniformly diffused into the light absorption layer 140 due to the selectively-formed barrier layer 120 even when the alkali-containing layer (not illustrated) is separately provided.

FIGS. 5 to 7 illustrate diagrams showing modifications to the structure illustrated in FIG. 4. Like FIG. 4, FIGS. 5 and 6 illustrate only the substrate 110 and the barrier layer 120 on the substrate 110.

Referring to both FIGS. 5 and 6, the thickness of the barrier layer 120 may be formed to be different between one point and another point, and may be formed to be greater at an edge portion than at a center portion. As described above, the substrate 110 may have a non-uniform temperature distribution in the heat treatment for forming the light absorption layer 140. Therefore, the barrier layer 120 may be formed to reflect the temperature distribution of the substrate 110 for uniform diffusion of the alkali elements.

For example, as illustrated in FIG. 5, the substrate 110 may be segmented into a first region B1, a second region B2, and a third region B3 according to the temperature distribution, and the barrier layer 120 may be formed to different thicknesses on the respective first, second, and third regions B1, B2 and B3. The temperature of the substrate 110 in the heat treatment may be highest at the first region B1 that is closest to the edge and is lowest at the third region B3 corresponding to the center portion. Accordingly, the thickness of the barrier layer 120 is formed to increase toward the edge.

The thickness of the barrier layer 120 may be set as illustrated and described with reference to FIGS. 2 and 3. The first to third regions B1 to B3 may be set in consideration of the temperature variation of the substrate 110.

In this manner, when the substrate 110 is segmented, for example, in a stepwise manner, into regions and the thickness of the barrier layer 120 formed on the respective regions is diversified, the alkali elements may be thermally-diffused more uniformly into the light absorption layer 140 in the heat treatment for forming the light absorption layer 140.

FIG. 6 illustrates a case where the barrier layer 120 is formed completely on the substrate 110, and the substrate 110 is segmented, for example, in a stepwise manner, into a first region C1, a second region C2, a third region C3, a fourth region C4, and a fifth region C5.

The thickness of the barrier layer 120 may be formed to increase toward the edge in the first to fifth regions C1 to C5. Also, the barrier layer 120 may be formed completely on the substrate 110. Accordingly, impurities other than the alkali elements may be effectively prevented from diffusing from the substrate 110 into the light absorption layer 140 in the heat treatment for forming the light absorption layer 140.

FIGS. 5 and 6 illustrate that the thickness of the barrier layer 120 increases discontinuously toward the edge of the substrate 110. However, in other implementations, since the temperature distribution of the substrate 110 may vary continuously, the thickness of the barrier layer 120 may be formed to vary continuously as FIG 7.

Although an example in which the temperature of the substrate 110 increases gradually toward the edge has been described above, in other implementations, the temperature of the substrate 110 may increase and then decrease toward the edge, or may decrease and then increase toward the edge. In these cases, the barrier layer 120 may be formed according to the temperature distribution of the substrate 110, such that the thickness of the barrier layer 120 may increase and then decrease toward the edge of the substrate 110, or may decrease and then increase toward the edge of the substrate 110.

Hereinafter, a method of manufacturing the solar cell 100 of FIG. 1 will be schematically described with reference to FIG. 1.

A method of manufacturing the solar cell 100, according to an embodiment, includes forming a barrier layer 120 on a substrate 110, forming a back electrode layer 130 on the barrier layer 120, forming a light absorption layer 140 on the back electrode layer 130, forming a buffer layer 150 on the light absorption layer 140, and forming a transparent electrode layer 160 on the buffer layer 150.

The barrier layer 120 may be formed by chemical vapor deposition, sputtering, or the like. In order to form the barrier layer 120 selectively on the substrate 110, the barrier layer 120 may be formed by screen printing, ink printing, or the like.

As described above, the barrier layer 120 may cause the alkali elements of the substrate 110 to be uniformly diffused into the light absorption layer 140. To this end, the barrier layer 120 may be formed to different thicknesses at the respective positions according to the non-uniform temperature distribution of the substrate 110.

Specifically, the barrier layer 120 may be formed to be thicker at the edge portion of the substrate 110, at which the temperature is higher in the heat treatment, than at the center portion of the substrate 110. Also, the thickness of the barrier layer 120 may increase toward the edge portion of the substrate 110. In this case, the thickness of the barrier layer 120 may increase discontinuously or continuously toward the edge portion of the substrate 110.

The back electrode layer 130 may be formed by applying conductive paste onto the substrate 110 and then performing heat treatment on the same, or may be formed through a plating process. Also, for example, the back electrode layer 130 may be formed through a sputtering process by using a Mo target.

After the forming of the back electrode layer 130, the back electrode layer 130 is divided into several parts through a first scribing process.

The light absorption layer 140 may be formed by a sputtering/selenization process that forms a CIG metal precursor film on the back electrode layer 130 by using a copper (Cu) target, an indium (In) target, and a gallium (Ga) target, and then forms a CIGS light absorption layer as the light absorption layer 140 by a reaction with the CIG metal precursor film by performing heat treatment in a hydrogen selenide ($H_2Se$) gas atmosphere. In other implementations, the light absorption layer 140 may be formed by various other methods. For example, the light absorption layer 140 may be formed by co-evaporation, electro-deposition, or molecular organic chemical vapor deposition (MOCVD), which inserts copper (Cu), indium (In), gallium (Ga), and Se into a small electric furnace installed in a vacuum chamber, and heats and vapor-deposits the same.

In the heat treatment for forming the light absorption layer 140, the substrate 110 may have a non-uniform temperature distribution in which the temperature is higher at the edge portion of the substrate 110. Therefore, as described above, the barrier layer 120 may be selectively formed such that the alkali elements of the substrate 110 may be uniformly diffused into the light absorption layer 140.

The buffer layer 150 may be formed by chemical bath deposition (CBD), atomic layer deposition (ALD), or ion layer gas reaction (ILGAR), as examples.

After the forming of the light absorption layer 140 and the buffer layer 150, the light absorption layer 140 and the buffer layer 150 may be divided into several parts through a second scribing process. The second scribing process may be performed at a position separate from the first scribing process.

The transparent electrode layer 160 may be formed by metalorganic chemical vapor deposition (MOCVD), low pressure chemical vapor deposition (LPCVD), or sputtering. After the forming of the transparent electrode layer 160, a third scribing process may be performed to segment a plurality of unit solar cells on the substrate 110.

By way of summation and review, interest in thin film solar cells, which have low unit production cost, is increasing. In particular, research into Group I-III-VI compound solar cells, which have relatively high photovoltaic efficiency, is increasing. The photovoltaic efficiency of a Group I-III-VI compound solar cell may increase when its light absorption layer includes alkali elements, such as sodium (Na). However, when alkali elements are non-uniformly distributed in the light absorption layer, the efficiency of the solar cell may decrease and the life of the solar cell may be shortened. Therefore, it is desirable to distribute alkali elements, such as Na, uniformly in the light absorption layer. More generally, it is desirable to distribute a dopant substantially uniformly in the light absorption layer, where the dopant is capable of improving the performance of the light absorption layer.

Embodiments provide solar cells in which alkali elements are uniformly distributed in a light absorption layer, and methods of manufacturing the same. Accordingly, the efficiency of the solar cell may be improved.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the invention as set forth in the following claims.

**Claims**

1. A solar cell, comprising:

   a substrate;
   a barrier layer on the substrate; and
   a light absorption layer;
   wherein the barrier layer has a variable thickness that is arranged to control diffusion of dopant into the light absorption layer.

2. The solar cell as claimed in claim 1, wherein the thickness of the barrier layer is greater towards an edge of the substrate.

3. The solar cell as claimed in claim 1 or claim 2, wherein the barrier layer is formed around a central portion of the substrate and is not formed in the central portion.

4. The solar cell as claimed in claim 1 or 2, wherein the thickness of the barrier layer increases discontinuously, increases discontinuously in a stepped manner or changes continuously.

5. The solar cell as claimed in any one of the preceding claims, wherein the substrate is formed of a material including the dopant.

6. The solar cell as claimed in any one of the preceding claims, comprising a layer including the dopant formed between the substrate and the barrier layer.

7. The solar cell as claimed in any one of the preceding claims, wherein:

   the light absorption layer is formed of a Group I-III-VI compound, and
   the light absorption layer includes the dopant, comprising alkali elements, diffused therein.

8. The solar cell as claimed in any one of the preceding claims, wherein the barrier layer is formed of at least one of silicon oxide, silicon nitride and silicon oxynitride.

9. The solar cell as claimed in any one of the preceding claims, further comprising:

   a back electrode layer on the barrier layer on which the light absorption layer is disposed;
   a buffer layer on the light absorption layer; and
   a transparent electrode layer on the buffer layer.

10. A method of manufacturing a solar cell having a light absorption layer, the method comprising:

   forming a barrier layer on a substrate with a thickness profile that is arranged to control diffusion of a dopant into the light absorption layer.

11. The method as claimed in claim 10, wherein the step of forming the light absorption layer includes heating the substrate so that dopant in the substrate or coated on the substrate is uniformly diffused into the light absorption layer, the method comprising forming the barrier layer to be thicker in portions where the substrate is heated to a higher temperature relative to other portions.

**12.** The method as claimed in claim 11, comprising increasing the thickness of the barrier layer towards the edge of the substrate.

**13.** The method as claimed in claim 12, wherein the thickness of the barrier layer increases in a discontinuous manner, increases in a stepped manner or increases in a continuous manner.

**14.** The method as claimed in any one of claims 10 to 13, comprising forming a back electrode layer on the barrier layer, wherein the light absorption layer is formed by forming a copper-indium-gallium metal precursor film on the back electrode layer and then performing heat treatment in a hydrogen selenide gas atmosphere.

**15.** The method as claimed in any one of claims 10 to 14, further comprising forming a buffer layer on the light absorption layer and forming a transparent electrode on the buffer layer.

FIG. 1

FIG. 2

FIG. 3

# FIG. 4

FIG. 5

FIG. 6

FIG. 7